# EUROPEAN PATENT APPLICATION

(11) **EP 2 518 373 A1**
(43) Date of publication of application: **31.10.2012**
(21) Application number: 10812838.0
(22) Date of filing: 21.12.2010
(51) Int. Cl.: F16J 9/26, C23C 14/06, C23C 14/16

(54) **PISTON RING**

(30) Priority: 21.12.2009 BR 0905186
(71) Applicant: Mahle Metal Leve S/A, 13214-970 Jundiaí - SP (BR)
(72) Inventor: AVELOR ARAUJO, Juliano, 13201-046 - Jundiaí - SP (BR)
(74) Representative: Burt, Matthew Thomas
(86) International application number: PCT/BR2010/000428
(87) International publication number: WO 2011/075804

(57) **Abstract**

This invention refers to a piston ring, particularly planned for use in internal combustion engines or compressors, including at least one metallic base (2) to which it is applied, by the physical vapor deposition (PVD) process, a multilayer coating (3) including a periodicity (P), formed by at least one first layer (5) and at least one second layer (5'), being the layers adjacent, bringing one first layer (5) predominantly formed by metallic chromium (5) and one second layer predominantly formed by ceramic chromium (5').

## Description

This invention refers to a piston ring, especially for use in internal combustion engines or various compressors, equipped with a plurality of alternated coating layers formed predominantly by a metal and a ceramic. As a result, the ring has excellent properties of resistance to abrasion and erosion.

### Description of the prior art

Internal combustion engines are constituted basically by two main parts: a cylinder block (where one or more cylinders and the set of the crankshaft are located), to which one or more cylinder heads are associated. The set of the crankshaft is composed of pistons, connecting rods and by the crankshaft, highlighting the fact that the piston is a cylindrical part, usually of an aluminum alloy, which moves inside the cylinder.

The space defined between the upper face of the piston, the wall of the cylinder and the base of the cylinder head corresponds to the combustion chamber, in that in Diesel engines, in general, the combustion chamber(s) is(are) defined predominantly by cavity(ies) provided in the piston head(s).

Inside the combustion chamber(s), the engine converts the chemical energy produced by the combustion of the mixture (fuel and air) into mechanical energy, capable of giving movement to the wheels.

Aiming at stopping the air/fuel mixture and the exhaust gases from leaking from the combustion chamber into the oil sump during the compression and the combustion and also stop the oil in the oil sump from going into the combustion zone, it is necessary to use rings to offer a sliding sealing between the external border of the piston and the internal wall of the cylinder.

During the movement of the piston inside the cylinder, the piston should totally adhere to the walls of the cylinder so as to stop the air/fuel mixture and the exhaust gases from leaking from the combustion chamber into the oil sump during the compression and the combustion and also stop the oil in the oil sump from going into the combustion zone. Because of the great attrition that such solution would provoke, the solution found was designing a small backlash between the piston and the internal walls of the cylinder, placing one or more rings around the piston in order to ensure the necessary isolation. This backlash also makes it possible to ensure space so that the piston can dilate with the heating of the engine without adhering to the walls of the involving cylinder, situation which would stop the movement of the piston.

Usually, the more modern 4-stroke engines use three rings in each piston - two compression rings and one oil ring. The two rings situated closer to the piston head are called compression segments and their purpose is to ensure that there is no escape of the gaseous mixture to the inside of the oil sump at the moment when the piston makes its compression movement. In the position that is farther from the piston head, the so called oil ring is situated, whose purpose is, when it moves (especially the movement away from the cylinder head), scraping the excess of oil on the cylinder wall and removing the excess, controlling the thickness of the oil 'film' and preventing its improper burning.

In general, the piston rings, especially the compression rings, are formed by a metallic base to which at least one layer of coating is applied, which gets in contact with the cylinder wall (to the working surface of the ring).

The role of the coating layer is very important, because its purpose is to bring to the ring properties of low sliding attrition, great resistance to spalling, hardness and tenacity. However, many of these properties are opposite, and an addition in one of them means a loss of performance in another one, and therefore the type of coating to be used will be chosen according to the profile of functioning of the engine and to the efforts to which the rings will be submitted during its service life.

A series of sophisticated coatings were suggested by experts in the subject, each one trying to enhance the desired properties. However, none of the coatings suggested until this moment were effective in increasing, simultaneously, the properties of absorption of internal stress, high hardness and low thickness, which greatly reduces the occurrence of spalling.

A first prior technique is represented by patent US 5.316.321, which refers to a piston ring for internal combustion engine manufactured with a titanium alloy, whose external sliding surface is coated by a hard film, using Physical Vapor Deposition ("PVD") for this deposition.

Document US 5.316.321 also describes the use of one or more types of films to coat the piston ring, especially TiN (Titanium Nitride) and CrN (Chromium Nitride).

A second prior technique developed is represented in the case of patent US 5.820.131, which reveals a piston ring with a coating formed by a film of a single layer of Cr₂N or a mixture of Cr₂N and CrN, with thickness of 3µm to 30µm and a percentage of nitrogen, in weight, between 11% and 17%. The coating layer is applied by the PVD process and its hardness oscillates between 1300 HV and 2000 HV.

Patent US 5.618.590 refers to a piston ring coated by a film of one or more layers applied by a cathodic arc deposition process.

Document US 5.618.590 also describes that the process applied is capable of forming a first layer that uses a metal (such as cobalt, nickel or molybdenum) that is not capable of forming a carbide or nitride and a second layer that uses a metal (such as titanium, vanadium, chromium, iron, zirconium, niobium, tungsten or silicon) capable or forming a carbide or nitride.

European patent EP 0.707.092 refers to a piston ring equipped with a coating layer formed by a mixture of metallic chromium and chromium nitride, applied by PVD. The document also describes that the concentration of nitrogen has a gradual increase from the metallic base to the exterior of the ring.

Another prior technique is represented by patent US 5.601.293, which reveals a piston ring with a coating formed by a single ternary layer consisting of molybdenum nitride, chromium nitride and a percentage of nitrogen, in weight, between 4% and 22%. The coating layer is applied by the PVD process and its hardness oscillates between 1400 HV and 2600 HV.

Japanese patent JP 6.293.954 refers to a piston ring coated by a single layer formed by at least chromium nitride by the PVD process. The crystal of the layer formed also has a columnar form that extends from the surface of the substrate to the surface of the nitrided layer.

The document of Japanese patent JP 6.248.425 describes a piston ring coated by a layer formed by CrN and/or Cr₂N, with a thickness that varies from 1 to 60 µm. Like in the document above, this document also describes that the formed layer consists of a crystal whose columnar shape extends from the surface of the substrate to the surface of the nitrided layer.

The Japanese application for patent JP 2006 316912 reveals a piston ring whose metallic base can be made of a steel, aluminum or titanium alloy and which uses a PVD process to create a superficial film with low rugosity. The document describes also that the film on the surface of the substrate can be constituted by combination of Ti and/or Cr, C, N and O.

Finally, a last representative prior technique can be found in patent US 6.631.907, which refers to a piston ring with a coating layer composed of CrN or Cr₂N, or, also, a mixture of nitrides, applied by PVD. The document includes also the application of a mixture of CrN with Cr₂N and metallic Cr, and vastly reports percentages in weight of the components.

Therefore, we call attention to the fact that none of the prior techniques refers to the formation of a multilayer coating, formed alternatively by ceramic/metallic layers based on chromium.

In other words, the piston ring object of this invention, by presenting an innovative constitution, takes ahead the properties brought by the coating layer. For the first time, a multilayer coating is suggested, composed of a plurality of consecutive Ceramic/Metallic layers, alternating in its majority composition chromium nitride (CrN) and metallic chromium (Cr).

As a result, we obtain a film with the best of the two components, because it brings the desirable properties of each ceramic and metallic layer, without making the weak points of each one stronger.

The best properties of each compound are made stronger, considering that the ductile metallic layers (Cr) make easier the accommodation of the hard ceramic layers (CrN), in that the latter grant to the coating a higher hardness and wear resistance, whereas the higher plasticity of the layer formed by the metallic chromium contributes to a significant reduction in the values of internal stress, making thicker coatings possible.

The coating developed now brings to the piston ring more wear resistance, lower modulus of elasticity and, simultaneously, a significant reduction in the values of internal stress, reducing the occurrence of cracks in the coating and the consequent spalling when compared to the prior techniques, especially those that use chromium nitride coatings.

### Purposes of the invention

This invention's purpose is a piston ring, particularly for use of internal combustion engine or compressor, equipped with a coating based on the concept of Ceramic/Metallic multilayers.

This invention's purpose is also a piston ring, particularly planned for use in internal combustion engines or compressors, including at least one metallic base to which one applies, by the physical vapor deposition process, a coating of metallic chromium and chromium nitride, in order to bring simultaneously the opposite properties of hardness, resistance to wearing, ductility and reduction of the modulus of elasticity and internal stress.

Also, this invention's purpose is a piston ring, particularly for use in internal combustion engines or compressor, equipped with a multiplicity of ceramic/metallic CrN/Cr coating layers, which have smaller thickness when compared to the thickness of the coating of the rings in the prior art with chromium nitride coating.

Finally, this invention's purpose is the process of application of a multiplicity of ceramic/metallic coating layers on a body of metallic piston ring, in a single application stage, by means of the variation of pressure of the nitrogen gas in the physical vapor deposition process.

### Brief description of the invention

The purposes of this invention are met by a piston ring, particularly designed for use in internal combustion engines or compressors, including at least one metallic base to which one applies, by the physical vapor deposition process (PVD), a coating that includes a periodicity, formed by at least one first layer and at least one adjacent second layer, in that the first layer is formed predominantly by metallic chromium and the second layer is formed predominantly by ceramic chromium.

### Summarized description of the drawings

This invention will be described in more details below, based on an execution example represented in the drawings. The figures show:
Figure 1 - a schematic transverse view of the piston ring object of this invention assembled on the small channel of a piston and in attrition with the wall of a cylinder.
Figure 2 - is an enlarged metallographic photo of the transverse section of the piston ring object of this invention, allowing view of the metallic base and the respective multilayer coating.

### Detailed description of the figures

Piston ring 1, object of this invention, is different from the ones that currently exist, essentially because of the advantageous and innovative characteristics of its coating 3.

We should point out that ring 1 is preferably a compression ring for use in 4-stroke internal combustion engines, in that ring 1 can very well have other concretizations, such as a ring to scrape oil, a ring applied onto a piston compressor, a ring of a 2-stroke engine or even any other possible concretization in which ring 1 brings a coating 3 with the innovative characteristics defined herein.

Whatever preferential configuration, the piston ring 1 of this invention includes at least one metallic base 2, to which a coating 3 with a plurality of layers (5,5') alternated between a metallic layer 5 and a ceramic layer 5', is applied by the physical vapor deposition (PVD) process.

Coating 3 is composed of metallic/ceramic multilayers 5,5' disposed so as to form at least two periodicities P where each periodicity is formed by at least one layer of metallic chromium 5 and at least one layer of ceramic chromium 5', adjacent.

Additionally, base 2 is composed of any metallic material appropriate to its formation, and it can present transverse section of various shapes, according to the characteristics of ring 1 and the work conditions according to which it will operate. To this end, one preferably uses any ferrous alloy appropriate to the composition of base 2, and it is clearly possible to use other materials in case there is interest and technical viability. More preferably, base 2 is composed of steel with 10 to 17% Chromium, usually known as stainless steel.

To base 2 one applies Metallic/Ceramic coating 3 based on chromium which grants to ring 1 properties of higher resistance to wearing, lower modulus of elasticity and, simultaneously, a significant reduction in the values of internal stress, reducing the occurrence of cracks in the coating and the consequent spalling when compared to the prior techniques, namely those which use single-layer chromium nitride coatings.

As mentioned above, coating 3 includes a plurality of Metallic/Ceramic layers 5,5' based on chromium arranged so as to form a periodicity P. Therefore, periodicity P includes at least two adjacent layers 5,5', mandatorily of different constitution, that is to say, one layer 5 has a predominantly metallic phase, and another layer 5' has a predominantly ceramic phase. Therefore, coating 3 will have at least four layers 5,5'.

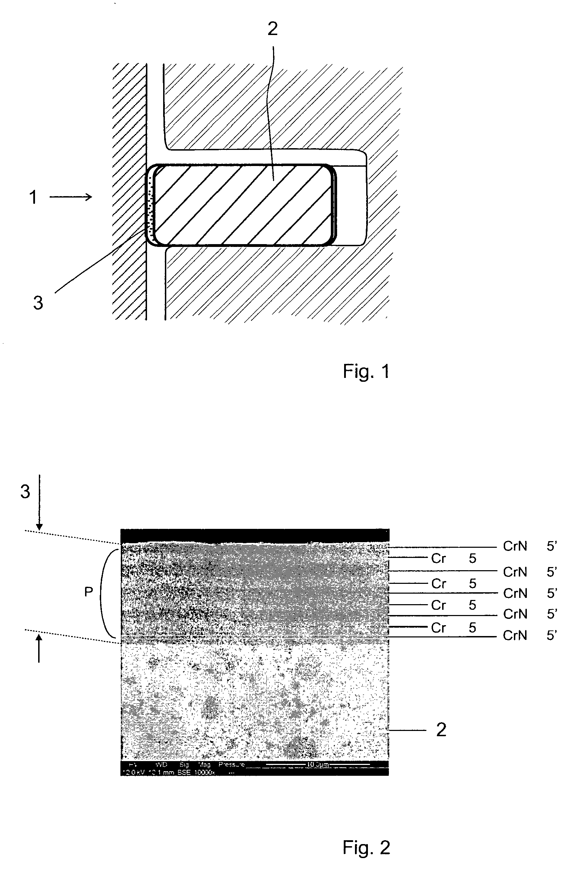

One of the qualities of metallic layer 5 which composes coating 3 includes chromium (Cr) in its metallic form (illustrated as the lighter layers in figure 2), whose most important mechanical characteristic is the higher ductility, characteristic which makes it easier to accommodate the hard ceramic layers 5'.

On the other hand, ceramic layer 5' includes chromium nitride (illustrated as the darker layers in figure 2), preferably in the form of CrN (although, evidently, there may be a reduced percentage of Cr₂N and/or other compounds/elements in its composition), having as most important mechanical characteristic its high hardness. It is especially important to notice that the chromium nitride of ceramic layer 5' can also predominantly come with the Cr₂N phase instead of the CrN phase.

Considering the foregoing, it is clear that the periodicity P has at least one metallic layer 5 predominantly composed of Cr and a ceramic layer 5' predominantly composed of CrN or Cr₂N.

Preferably, as illustrated in figure2, the metallic layer 5 must be positioned adjacently to the ceramic layer 5' or vice-versa. Consequently, it is possible to ensure that the coating layers 5,5' are alternated with no repetition.

We should also point out that any of the layers 5,5' can be deposited on the surface of base 2, and it is therefore possible to deposit as first layer on base 2 both metallic layer 5 and ceramic layer 5'. Naturally, after each deposited layer, one shall alternate a different layer, that is, if the first layer to be deposited on the surface of base 2 is ceramic layer 5', the metallic layer 5 shall follow, or vice-versa, and then successively.

Alternatively, one may conceive a ring 1 according to the teachings of this invention, in which there may be, as an exception, two adjacent layers of equal quality, depending on the qualities of resistance and ductility that one wishes to grant to coating 3.

As can be clearly seen in figure 2, coating 3 of the preferable concretization of ring 1 includes nine metallic/ceramic layers 5,5', where the qualities of layers 5,5' of coating 3 are alternated with no repetition.

If necessary or desirable, layers 5,5' can include one or more additional chemical elements, in varied proportions, calculated according to the mechanical property one wishes to meet. Even with the occurrence of a mixture in the individual layers 5,5', it is expected to reach the same degree of advantages, that is to say, the already mentioned advantages of this invention are also expected with a multilayer 5,5' coating 3, where a layer has ceramic predominance and the subsequent layer has metallic predominance.

Likewise, the same advantages are expected to be met in case one uses similar elements to provide a metallic/ceramic multilayer coating. Such possible chemical elements may be present in at least one of the layers 5,5', in some of them or in all of them, according to the mechanical properties of the coating that one wishes to obtain provided that the characteristics of a metallic/ceramic multilayer coating are maintained.

Please find below a comparison table referring to the various properties achieved by this invention and the prior art.

| Coating/ Results | Multilayers CrN/Cr | Monolayer CrN |
|---|---|---|
| Hardness | 1350 HV | 1200 HV |
| Young's Modulus | 200 MPa | 250 MPa |
| Internal Stress | -310 N/mm² | -1100 N/mm² |
| Scratch Test | 135 N | 110 N |

As we can see in the table above, coating 3 of this invention obtained really superior results in all measured characteristics. We confirm, therefore, an increase in the values for opposite properties, a fact that really proves the success of coating 3 of this invention.

Therefore this invention, when compared to the typical CrN monolayer coating, reaches a value for the modulus of elasticity that is considerably lower and a significant reduction in the internal stress (considerably 3.5 times lower).

These values make it clear that there is an increase of adhesion energy due to the reduction of internal stress and an increase of the elastic energy, enabled by the reduction of the modulus of elasticity.

Figure 2 shows a coating 3 with two different layers 5,5' where the difference is basically in the content of chromium, expecting, therefore, cohesive borders between the Metallic/Ceramic layers 5,5' in order to guarantee adhesion between the layers 5,5' avoiding, as a result, the propagation of cracks on its interface.

Consequently, with the use of coating 3 of this invention, the reduction in the values of internal stress is translated into a much higher resistance to the spalling phenomenon, in which small portions of the coating are unplated due to the occurrence of microcracks caused by the accumulation of tensions and by the low ductility. The great structural technical inconvenience is that the spalling tends to occurs in certain areas of the ring, whereas in other areas the coating remains intact or little damaged even at the end of the service life of the part.

This reduction in the values of internal stress brings with it the advantages of enabling an increase in the adhesion energy of the layers among themselves with a resulting reduction in the thickness of the coating, which is possible since one can obtain a great reduction in the spalling, making sure that, even with reduced thickness, there will be coating 3 during the whole operational life of the ring.

In turn, the results obtained in the scratch test are also, in the case of this invention, significantly superior, revealing that CrN/Cr multilayer coating 3 has more tenacity than the coating in the prior art (Cr monolayer coating), contributing, in an effective manner, to a higher resistance to delamination of the coating.

It is, therefore, evident that Metallic/Ceramic 5,5' multilayer coating 3 of this invention, with structure preferably of metallic chromium and chromium nitride (in the CrN or Cr₂N phase), offers a clear improvement in the commitment between a higher capacity of absorbing the stress simultaneously with a higher resistance to the superficial propagation of cracks due to the better characteristics of resistance to stress in the external shearing, a fact which results in a superior performance of coating 3 of this invention for piston rings 1 concerning the cohesive adherence (resistance to delamination).

The deposition process applied in this invention is a physical vapor deposition (PVD) process, preferably by cathodic arc, or Arc-PVD, which is a PVD technique where an electric arc is used to vaporize material from a cathode target. The vaporized material then condenses on a substrate, forming a thin film.

Essentially, the control of gas pressure (for example, nitrogen) used enables the production of the layers 5,5' sequentially, in that the layers composed of chromium nitride have a percentage of Nitrogen atoms between 22% and 25% in weight, whereas the layers composed of metallic chromium have substantially 0% of Nitrogen atoms. To avoid the interference of the different levels of nitrogen in each layer 5,5', high speeds of pumping are applied through turbopumps.

The thickness and periodicity values are considered very stable in the whole coating (see figure 2); however, the layers 5,5' follow the deformities of base 2, resulting in the shapes visible in figure 2.

In the case of coating 3 of this invention, the highest hardness is obtained with the composition of chromium nitride and the higher ductility, in turn, is obtained with the use of metallic chromium. The combination of these two compositions in the form of layers 5,5', as mentioned above, brings surprising advantages, especially in the benefit brought in coating 3 as a whole for its higher capacity of absorption of internal stress. Layers 5 of metallic chromium, more ductile, absorb the efforts and deform, decreasing, therefore, the forces of deformation to which chromium nitride layers 5', more rigid, are submitted, bringing a lower tendency of appearance of microcracks in them. The result is a considerable increase in the performance of ring 1.

Also, because of the fact that the ductile chromium metallic layers 5 allow a better accommodation of the harder chromium nitride ceramic layers 5, what occurs is a reduction of the thickness of coating 3 without losing resistance to wearing.

The preferred concretization of ring 1, illustrated in figure 2, brings a superficial hardness of 1000 to 2,000 HV, and it is preferably around 1350 HV, with internal stress of about -310 N/mm². Preferably, the thickness of the coating (3) has values ranging substantially from 10 to 60 microns, that is, it has very reduced thickness *(nanolayer).*

Optionally, an adhesion layer can be offered composed of chromium, nickel or cobalt positioned between the base 2 and coating 3.

Preferably, coating 3 is applied on the whole external surface of ring 1, but nothing prevents it from being applied in determined areas, being partially removed or also from having an application of any other quality of coating on top of it. A piston ring formed like this is still included in the scope of protection of the claims.

Having examples of preferred concretizations been described, one must understand that the scope of this invention comprehends other possible variations, and it is limited only by the content of the claims attached, including possible equivalent ones.

## Claims

1. Piston ring, particularly planned for use in internal combustion engines or compressors, including at least one metallic base (2) to which it is applied, by the physical vapor deposition (PVD) process, a coating (3) that includes a periodicity (P), formed by at least one first layer (5) and at least one second layer (5'), being the layers adjacent, **characterized by** the fact that the first layer (5) is predominantly formed by metallic chromium (5) and the second layer is predominantly formed by ceramic chromium (5').

2. Ring according to claim 1, **characterized by** the fact that the periodicity is composed of only two adjacent layers (5,5'), where the first layer (5) is predominantly formed by metallic chromium (5) and the second layer is predominantly formed by ceramic chromium (5').

3. Ring according to claim 1 or 2, **characterized by** the fact that the first and second layers (5,5') contain an additional chemical element selected among the group composed of Oxygen or Carbon in a percentage not above 10% in mass.

4. Ring according to claim 1, **characterized by** the fact that the Vickers hardness of the coating has values between 1,000 and 2,000 HV.

5. Ring according to claim 1, **characterized by** the fact that the thickness of the coating (3) has values ranging from 10 to 60 microns.

6. Ring according to claim 5, **characterized by** the fact that the coating (3) is *nanolayer.*

7. Ring according to claim 1, **characterized by** the fact that the base (2) is composed of steel with 10% to 17% of Chromium.

8. Ring according to claim 1, **characterized by** the fact that the base (2) is composed of cast iron.

9. Ring according to claim 1, **characterized by** the fact that the ceramic chromium that constitutes the second layer (5') is preferably Chromium nitride (CrN) and this second layer has a percentage of Nitrogen, in weight, between 11 % and 17%.

10. Ring according to claim 1, **characterized by** the fact that the chromium nitride layer (5') can have CrN or Cr₂N phase.

11. Ring according to claim 1, **characterized by** the fact that it has an adhesion layer composed of chromium, nickel or cobalt positioned between the base (2) and the coating (3).
